(19) Europäisches Patentamt
European Patent Office
Office européen des brevets

(11) **EP 2 640 177 A1**

# EUROPEAN PATENT APPLICATION
published in accordance with Art. 153(4) EPC

(43) Date of publication:
**18.09.2013 Bulletin 2013/38**

(21) Application number: **11839878.3**

(22) Date of filing: **10.11.2011**

(51) Int Cl.:
*H05K 9/00* (2006.01)      *F03D 11/00* (2006.01)

(86) International application number:
**PCT/KR2011/008562**

(87) International publication number:
**WO 2012/064125 (18.05.2012 Gazette 2012/20)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.11.2011   KR 20110116597
12.11.2010   KR 20100112699
10.11.2010   KR 20100111425**

(71) Applicant: **Korea Institute of Machinery and Materials
Daejeon 302-343 (KR)**

(72) Inventors:
• **KIM, Jin Bong
Gimhae-si
Gyeongsangnam-do 621-723 (KR)**

• **KIM, Byung Sun
Changwon-si
Gyeongsangnam-do 641-761 (KR)**
• **BYUN, Joon Hyung
Busan 608-090 (KR)**
• **HWANG, Byung Sun
Changwon-si
Gyeongsangnam-do 642-777 (KR)**
• **UM, Moon Kwang
Changwon-si
Gyeongsangnam-do 641-777 (KR)**
• **PARK, Ji Sang
Changwon-si
Gyeongsangnam-do 641-780 (KR)**

(74) Representative: **Office Freylinger
P.O. Box 48
8001 Strassen (LU)**

(54) **ELECTROMAGNETIC WAVE ABSORBER USING A DIELECTRIC LOSS SHEET, METHOD FOR FORMING THE ELECTROMAGNETIC WAVE ABSORBER, AND ROTARY BLADE FOR A WIND TURBINE HAVING AN ELECTROMAGNETIC WAVE FUNCTION USING SAME**

(57)      Disclosed are an electromagnetic wave absorber using a dielectric loss sheet, a method for fabricating the same, and a wind turbine blade having an electromagnetic wave function. The electromagnetic wave absorber comprises: a support layer for providing a resonant space of electromagnetic waves; a highly conductive backing layer assigned to a back surface of the dielectric support layer; and a dielectric lossy composite sheet layer formed on a front surface of the dielectric support layer, said dielectric lossy composite sheet layer having such a dielectric permittivity so as to generate a resonant peak with the electromagnetic waves reflected from the highly conductive backing layer.

FIGURE 5

**Description**

**Technical Field**

The present invention relates to absorption and shielding of electromagnetic waves. More particularly, the present invention relates to an electromagnetic wave absorber which exhibits a broad absorption bandwidth and has a thin support layer necessary for matching thereof, while retaining the advantage of a Salisbury screen-type absorber in terms of fabrication and structure, and to a method for fabricating the same.

Also, the present invention is concerned with a wind turbine blade having an electromagnetic wave absorption function, and a method for the fabrication thereof, wherein the wind turbine blade having an electromagnetic wave absorption function comprises an electromagnetic wave absorber the dielectric support layer of which employs a part of a composite for a turbine blade.

**Background Art**

With the development of various electromagnetic devices operating in a high-frequency band, the wireless communication market has rapidly been expanded in recent years.

Accordingly, there has been much study on the shielding and absorption of electromagnetic waves in order to increase compatibility of electromagnetic devices and reliability of wireless communication in the environment of electromagnetic magnetic pollution.

Electromagnetic wave shielding is the practice of reducing an electromagnetic field in a space across a barrier by reflecting or absorbing electromagnetic waves incident on the barrier, while electromagnetic wave absorption refers to reduction in intensity of electromagnetic waves both reflected by and transmitted through an absorber by transforming the energy of incident electromagnetic waves into thermal energy.

In contrast to electromagnetic shielding, electromagnetic wave absorption does not produce secondary electromagnetic pollution ascribed to reflected electromagnetic waves, and thus may be said to be an advanced technology.

Generally adapted to be added to a preexisting structure, an electromagnetic wave absorber should be thin, low in specific gravity, and wide in absorption bandwidth.

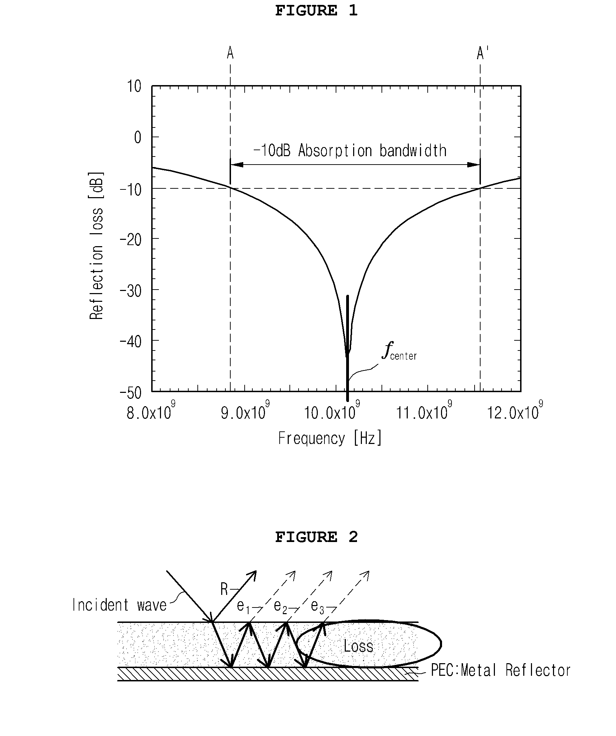

Referring to FIG. 1, absorption performance of a typical resonant electromagnetic wave absorber with a center frequency of 10 GHz is shown.

As shown in the graph of FIG. 1, a resonant electromagnetic wave absorber with a specific center frequency is designed to have a certain absorption bandwidth because its return loss dips at the center frequency and becomes more reflective as the frequency moves away from the center frequency.

The most widely used absorption bandwidth is a -10 dB bandwidth, which means the absorption of 90 % of electromagnetic waves as thermal energy.

Resonant electromagnetic wave absorbers are structurally divided into a Dallenbach layer and a Salisbury screen.

FIG. 2 is a schematic cross-sectional view of a typical Dallenbach layer-type absorber.

With reference to FIG. 2, the Dallenbach absorber is composed of an absorption layer and a back layer. The absorption layer is made of a conduction loss material, a magnetic loss material, a dielectric loss material, a sintered material having two or more different losses, or a composite thereof, and exhibits an absorption mechanism dependent fundamentally on the high frequency loss characteristics of the absorption layer material.

On the whole, a Dallenbach absorber has an absorption layer as thick as several millimeters which may require a large quantity of materials when it is used over a large area, and the single or composite lossy materials used in the absorption layer are poor in mechanical and chemical properties. Thus, the conventional absorption layer suffers from the disadvantage of increasing the weight of the structure and being vulnerable to mechanical and chemical environments.

The matching thickness (d) of the Dallenbach absorber may be accounted for by the complex permittivity ($\varepsilon=\varepsilon$'-$j\varepsilon$'') and complex permeability ($\mu=\mu$'-$j\mu$'') of the absorption layer, and can be represented by the following Math Formula 1:

[Math Formula 1]

$$d < \frac{\lambda}{4\sqrt{|\mu\varepsilon|}}$$

wherein $\lambda$ is a wavelength of the electromagnetic wave in air, and $\frac{\lambda}{\sqrt{\mu\varepsilon}}$ is a wavelength of the electromagnetic wave within the absorption layer. $\dfrac{\lambda}{4\sqrt{\mu\varepsilon}}$ represents a thickness (d) necessary for the electromagnetic wave incident from the air to the absorption layer to show a phase difference of n/ 2 for the time during which the incident electromagnetic wave propagates to the back layer and is then reflected toward the border between the air and the absorption layer.

When electromagnetic waves are transmitted or reflected at a border between air and an absorption layer, an additional phase difference ($\theta$) occurs due to combinations between the real part ($\varepsilon$') and the imaginary part ($\varepsilon$") in the complex permittivity, and between the real part ($\mu$') and imaginary part ($\mu$'') in the complex permeability.

This phase difference ($\theta$) makes the matching thickness (d) of the Dallenbach absorber smaller than $\dfrac{\lambda}{4\sqrt{\mu\varepsilon}}$.

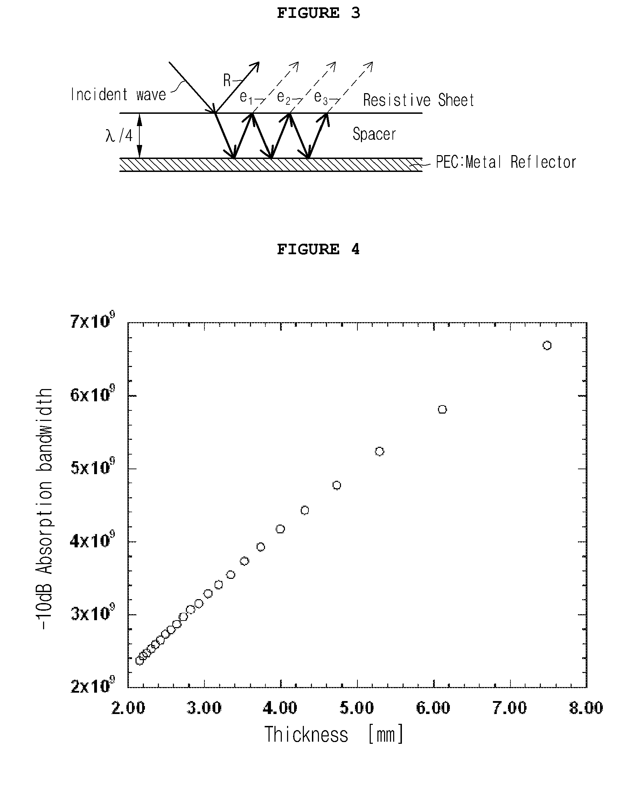

FIG. 3 is a schematic cross-sectional view of a conventional Salisbury screen-type absorber.

With reference to FIG. 3, the Salisbury screen-type absorber comprises a support layer made of a dielectric substance which exhibits a very small electromagnetic wave loss, such as a foam core or a glass fiber-reinforced composite, and a resistive sheet ranging in thickness from micrometers to tens of micrometers with a sheet resistance of 377 $\Omega$/sq.

Compared to the Dallenbach layer-type absorber, the Salisbury screen-type absorber is structurally simpler and easier to fabricate.

The matching thickness (d) of the Salisbury screen-type absorber can be accounted for by the dielectric constant ($\varepsilon$) of the dielectric substance, and is represented by the following Math Formula 2:

[Math Formula 2]

$$d=\frac{\lambda}{4\sqrt{|\varepsilon|}}$$

wherein $\lambda$ is a wavelength of the electromagnetic wave in air, and $\dfrac{\lambda}{\sqrt{|\varepsilon|}}$ is a wavelength of the electromagnetic wae within the absorption layer.

FIG. 4 is a plot of -10 dB bandwidths of as a function of thicknesses of the absorption layer in a Salisbury screen-type absorber with a center frequency of 10 GHz.

That is, the absorption bandwidth of a Salisbury screen-type absorber is proportional to the thickness of the support layer defined in Math Formula 2.

Referring to FIG. 4 and Math Formula 2, a support layer made of a substance (e.g., foam core) with a dielectric constant similar to that of air (dielectric constant $\varepsilon$=1.0) must be 7.495 mm in thickness (d), having a bandwidth of 6.68 GHz.

When a glass fiber-reinforced composite (with an absolute value of dielectric constant $|\varepsilon|$=4.7) is used as a material for the support layer, the thickness of the support layer amounts to about 3.47 mm, having a bandwidth of 3.60 GHz.

When used, E-Glass with a dielectric constant of about 6.0 must be fabricated into an absorption layer about 3.06 mm thick with a bandwidth of 3.28 GHz.

As a rule, a Salisbury screen-type absorber is thicker than a Dallenbach layer-type absorber since the dielectric constant ($\varepsilon$) of its absorption layer is smaller than the complex permittivity ($\varepsilon$) and complex permeability ($\mu$) of the absorption layer of the Dallenbach layer-type absorber.

Further, the Salisbury screen- type absorber is narrower in absorption bandwidth per unit thickness than the Dallenbach layer- type absorber.

**Disclosure**

**Technical Problem**

It is an object of the present invention to provide an electromagnetic wave absorber, comprising a conductive powder-dispersed composite sheet layer having complex permittivity with controlled real and imaginary parts, and a dielectric support layer which is reduced in matching thickness and exhibits a broad absorption bandwidth, and a method for fabricating the same.

It is another object of the present invention to provide a wind turbine blade having an electromagnetic wave absorption function, in which a dielectric material used in a wind turbine blade is employed as a support layer for an electromagnetic wave absorber to allow the avoidance of radar interference.

**Technical Solution**

In accordance with an aspect thereof, the present invention provides an electromagnetic wave absorber, comprising a support layer for providing a resonant space of  electromagnetic waves, a highly conductive backing layer assigned to a back surface of the dielectric support layer, and a dielectric lossy composite sheet layer formed on a front surface of the dielectric support layer, said dielectric lossy composite sheet layer having such a dielectric permittivity so as to generate a resonant peak with the electromagnetic waves reflected from the highly conductive backing layer.

According to one embodiment of the electromagnetic wave absorber, the dielectric lossy composite sheet layer comprises a polymer matrix with a conductive powder dispersed therein, and exhibits complex permittivity.

In this regard, the complex permittivity may vary depending on a factor selected from the group consisting of content, morphology, inherent electrical conductivity, and surface condition of the dispersed conductive powder.

In another embodiment of the electromagnetic wave absorber, the complex permittivity may vary depending on a thickness of the composite sheet layer.

In a further embodiment of the electromagnetic wave absorber, the complex permittivity may vary depending on a center frequency of the absorber, and a thickness of the support layer.

In still another embodiment of the electromagnetic wave absorber, the complex permittivity has a real part of greater than 1.

In a still further embodiment of the electromagnetic wave absorber, the composite sheet layer may be formed by applying an epoxy resin in which carbon black, carbon nanofibers, or carbon nanotubes are homogeneously dispersed to a glass fiber fabric.

In yet another embodiment of the electromagnetic wave absorber, the composite sheet layer may comprise a carbon nanomaterial.

In a further embodiment of the electromagnetic wave absorber, the glass fiber fabric is a plain weave fabric which has small cells and is slightly different in fiber count between fill and warp directions, and which is used as a thin PCB insulation mat.

In accordance with another aspect thereof, the present invention provides an electromagnetic wave absorber, comprising: a support layer for providing a resonant space of electromagnetic waves, a highly conductive backing layer assigned to a back surface of the dielectric support layer, and a multi-ply composite sheet layer formed on the dielectric support layer, said multi-ply composite sheet layer having such a dielectric permittivity so as to generate a resonant peak with the electromagnetic waves reflected from the highly conductive backing layer.

In one embodiment of the electromagnetic wave absorber, at least one ply of the multi-ply composite sheet layer is  formed by coating a glass fiber fabric with an epoxy resin in which carbon black, carbon nanofibers, or carbon nanotubes are homogenously dispersed.

In accordance with a further aspect thereof, the present invention provides a method for fabricating an electromagnetic wave absorber, comprising providing a dielectric support layer for a resonant space of electromagnetic waves, assigning a highly conductive backing layer to a back surface of the dielectric support layer, and forming a dielectric lossy composite sheet layer on a front surface of the dielectric support layer, said dielectric lossy composite sheet layer having such a complex permittivity so as to generate a resonant peak with an electromagnetic wave reflected from the highly conductive backing layer.

In one embodiment of the method, the dielectric lossy composite sheet layer is formed in such a way that conductive powders are homogenously dispersed in a polymer matrix to endow the dielectric lossy composite sheet layer with complex permittivity.

According to another embodiment of the method, the complex permittivity may vary depending on a factor selected from the group consisting of content, morphology, inherent electrical conductivity, and a surface condition of the dispersed conductive powder.

In a further embodiment of the method, the complex  permittivity may vary depending on a thickness of the composite sheet layer.

In still another embodiment of the method, the complex permittivity may vary depending on a center frequency of the absorber and a thickness of the support layer.

In a still further embodiment of the method, the thickness of the composite sheet layer may vary depending on a center frequency of the absorber and a thickness of the support layer.

According to yet another embodiment of the method, the complex permittivity consists of a real part (e') and an imaginary part (e''), and has a value exceeding 1.

In a yet further embodiment of the method, the composite sheet layer is formed by coating a glass fiber fabric with an epoxy resin in which carbon black, carbon nanofibers, or carbon nanotubes are homogenously dispersed.

In yet another embodiment of the method, the composite sheet layer comprises a carbon nanomaterial.

In a still further embodiment of the method, the glass fiber fabric is a plain weave fabric which has small cells and is slightly different in fiber count between fill and warp directions, and which is used as a thin PCB insulation mat.

In an additional embodiment of the method, the epoxy resin is based on a bisphenol-A type resin with an aromatic amine-type curing agent plus a diluent for easy application to a fabric, and a small amount of a reaction accelerator.

In accordance with a further aspect thereof, the present invention provides a wind turbine blade, comprising a composite in a sandwich structure consisting of an internal face layer, a core, and an external face layer, an electromagnetic wave absorbing screen located below the external face layer, and a resin-permeable, highly conductive backing layer inserted into the sandwich-type composite, functioning to reflect electromagnetic waves.

According to one embodiment of the wind turbine blade, the electromagnetic wave absorbing screen is formed by coating a glass fiber fabric including an epoxy resin in which a carbon nanomaterial is homogeneously dispersed.

In another embodiment of the wind turbine blade, the carbon nanomaterial is selected from the group consisting of carbon black, carbon nanofibers, carbon nanotubes, and a combination thereof.

In a further embodiment of the wind turbine blade, the electromagnetic wave absorbing screen is selected from the group consisting of a dielectric lossy composite sheet, a resistive sheet with sheet resistance of 377 $\Omega$/sq, and a circuit analog.

In still another embodiment of the wind turbine blade, the resin-permeable, highly conductive backing layer is formed by stacking at least one carbon fabric.

In a still further embodiment of the wind turbine blade, the resin-permeable highly conductive backing layer is inserted into the external face layer, between the external face layer and the core, or into the core.

In yet another embodiment of the wind turbine blade, the resin-permeable highly conductive backing layer is located at any position in a thickness direction within the core.

According to a yet further embodiment of the wind turbine blade, the resin-permeable, highly conductive backing layer has a permeability coefficient of $10^{-6} \sim 10^{-14}$ m$^2$ against a flow of a liquid resin in a thickness direction, as calculated according to the following Math Formula.

$$U = \frac{K}{\mu} \frac{\delta p}{\delta x}$$

(U: flow rate [m/s], K: permeability coefficient of medium [m$^2$], $\delta p/\delta x$: pressure gradient in thickness direction [N/m$^2$], $\mu$: viscosity [N·s/m$^2$])

In still another embodiment of the wind turbine blade, the resin-permeable, highly conductive backing layer has electromagnetic wave reflectivity of 95 %.

In a still further embodiment of the wind turbine blade, the composite in a sandwich structure comprises an internal face layer, an external face layer, and a core sandwiched therebetween, both said internal face layer and said external face layer being made of a glass fiber-reinforced composite, and said core being made of a non-conductive dielectric selected from the group consisting of a foam and balsa wood.

In accordance with still another aspect thereof, the present invention provides a method for fabricating a wind turbine blade having an electromagnetic wave absorbing function, comprising forming an electromagnetic wave absorbing screen by coating a glass fiber fabric with an epoxy resin in which a carbon nanomaterial is homogeneously dispersed, selecting a position at which a resin-permeable, highly conductive backing layer is to be located, constructing a composite in a sandwich structure with the resin-permeable, highly conductive backing layer located therein by laminating an internal face layer, a core, and an external face layer in that order, and layering the composite on the electromagnetic wave-absorbing screen.

In one embodiment, the method may further comprise placing the electromagnetic wave absorbing screen on a mold.

In another embodiment of the method, the selecting is carried out by inserting the resin-permeable highly conductive backing layer into the external face layer, between the external face layer and the core, or into the core.

In a further embodiment of the method, the resin-permeable highly conductive backing layer is inserted into the core at any position in a thickness direct of the core.


**Advantageous Effects**


As described above, the electromagnetic wave absorber fabricated using the method of the present invention exhibits a broad absorption bandwidth with a relatively narrow matching thickness of the support layer while retaining the methodological and structural advantages of a conventional Salisbury screen-type absorber.

In addition, the wind turbine blade having an electromagnetic wave absorption function, fabricated using the method of the present invention, utilizes a dielectric material used in a wind turbine blade as a support layer for an electromagnetic wave absorber, thereby avoiding radar interference.

Furthermore, in the present invention, a part of a wind turbine blade is employed as a support layer for an electromagnetic wave absorber to allow the avoidance of radar interference without requiring an additional absorber, thus reducing a burden on production cost, fabrication time, and maintenance.

## Description of Drawings

FIG. 1 is a graph showing the absorption performance of a typical resonant electromagnetic wave absorber with a center frequency of 10 GHz.

FIG. 2 is a schematic cross-sectional view of a typical Dallenbach layer-type absorber.

FIG. 3 is a schematic cross-sectional view of a conventional Salisbury screen-type absorber.

FIG. 4 is a plot of -10 dB bandwidths of as a function of thicknesses of the absorption layer in a Salisbury screen-type absorber with a center frequency of 10 GHz.

FIG. 5 is a cross-sectional view of an electromagnetic wave absorber utilizing a dielectric lossy sheet in accordance with an embodiment of the present invention.

FIG. 6 is a graph in which the complex permittivity of a 2 mm-thick dielectric lossy composite sheet layer, necessary for the matching in an electromagnetic wave absorber with a center frequency of 10 GHz designed to have a glass fiber-reinforced epoxy laminate as a support layer for the composite sheet layer, is plotted according to the thickness of the glass fiber/epoxy laminate.

FIG. 7 is a graph showing the complex permittivity of the dielectric lossy composite sheet layer of FIG. 5 according to thickness.

FIG. 8 shows plots of the complex permittivity of composite sheet layers containing carbon black, carbon nanofibers, and carbon nanotubes as conductive powders, respectively.

FIG. 9 shows graphs in which reflection losses of the composite sheet layers containing carbon black, carbon nanofibers, and carbon nanotubes as conductive powders, respectively, in electromagnetic wave absorbers with a center frequency of 10 GHz, are plotted against frequency.

FIG. 10 is a graph in which -10 dB bandwidths of the electromagnetic wave absorbers shown in FIG. 5 of the present invention and in FIG. 3 are plotted against thickness.

FIG. 11 is a schematic view illustrating the application of the electromagnetic wave absorber of FIG. 5 to general structures.

FIG. 12 is a cross-sectional view of an airfoil upper or lower plate for wind turbine blades, provided with a function of electromagnetic wave absorption in accordance with an embodiment of the present invention.

FIGS. 13 and 14 are flowcharts illustrating a method for fabricating a wind turbine blade having an electromagnetic wave absorbing function in accordance with an embodiment of the present invention.

FIG. 15 is a schematic cross-sectional view of the structure of a wind turbine blade having an electromagnetic wave absorbing function in accordance with one embodiment of the present invention when elements are arranged, as shown in FIG. 3, using SCRIMP.

FIG. 16 is a graph showing electromagnetic wave reflectance and transmittance properties of carbon fabrics for use in the highly conductive backing layer.

FIGS. 17a to 17c are plots of the complex permittivity of dielectric lossy electromagnetic wave-absorbing screens containing carbon black, carbon nanofibers, and carbon nanotubes as conductive powders, respectively.

FIGS. 18a to 18c are reflection loss graphs showing the absorption performance of wind turbine blades fabricated with the dielectric lossy electromagnetic wave absorbing screen.

## Mode for Invention

Reference should now be made to the drawings, throughout which the same reference numerals are used to designate the same or similar components. Below, a description will be given of preferred embodiments of the present invention in conjunction with the accompanying drawings. Throughout the accompanying drawings, the same reference numerals are used to designate the same or similar components. It should be apparent to those skilled in the art that, although many specified elements such as concrete components are elucidated in the following description, they are intended to aid the general understanding of the invention and the present invention can be implemented without the specified elements. Further, in the description of the present invention, when it is determined that the detailed description of the related art would obscure the gist of the present invention, the description thereof will be omitted.

Unless the context clearly requires otherwise, throughout the description and the claims, the words "comprise," "comprising," and the like are to be construed in an inclusive sense as opposed to an exclusive or exhaustive sense, that is to say, in the sense of "including, but not limited to." In addition, the words "~ part" and "~ unit" are intended to refer to a unit for processing at least one function or operation and can be realized by hardware, software, or a combination thereof.

In order to fully understand the operational advantages of the present invention and the objects achieved by the embodiment of the present invention, reference must be made to the accompanying drawings illustrating preferred embodiments of the present invention, and the disclosure of the drawings.

Preferred embodiments of the present invention will be explained in detail in conjunction with the accompanying drawings, in which the same reference numerals are used throughout the different drawings to designate the same or similar components.

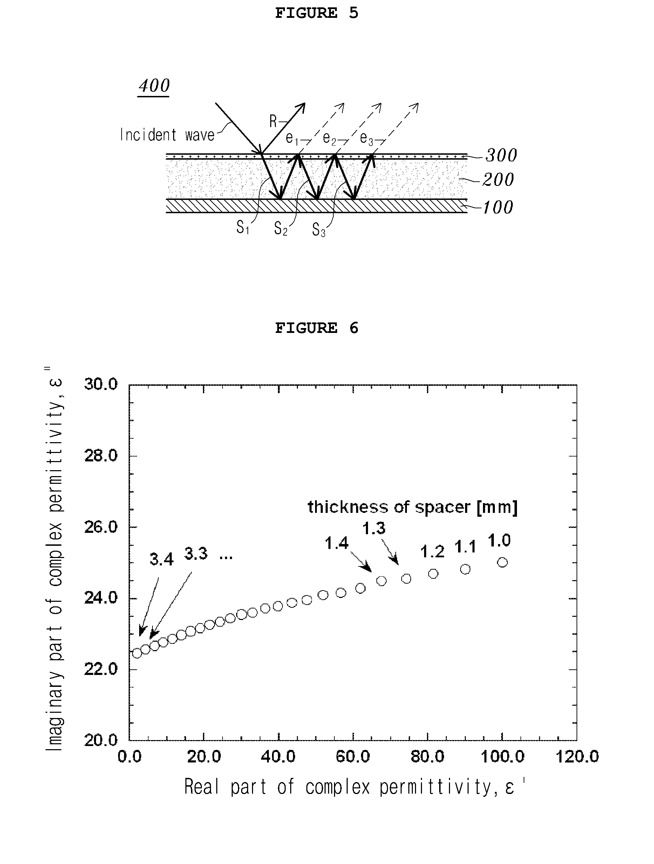

FIG. 5 is a cross-sectional view of an electromagnetic wave absorber utilizing a dielectric lossy sheet in accordance with an embodiment of the present invention.

With reference to FIG. 5, an electromagnetic wave absorber 400 using a dielectric lossy sheet in accordance with the present invention is shown.

As can be seen in the cross-sectional view of FIG. 5, the electromagnetic wave absorber 400 using a dielectric lossy sheet in accordance with the present invention comprises a support layer 200, a highly conductive backing layer 100, and a composite sheet layer 300.

In the electromagnetic wave absorber, the backing layer 200 serves to provide a space for the resonance of electromagnetic waves.

The highly conductive backing layer 100 may be formed on the back surface of the support layer.

On the front surface of the support layer is assigned the composite sheet layer 300 that has such a complex permittivity so as to generate a resonant peak with an electromagnetic wave reflected from the highly conductive backing layer 100.

The composite sheet layer 300, characteristic of the present invention, is a polymer matrix with a conductive powder dispersed therein, and exhibits various levels of complex permittivity depending on various factors including the dispersed conductive powder's content, morphology, inherent electrical conductivity, and surface condition.

When it is incident on the electromagnetic wave absorber 400, an electromagnetic wave is separated into a wave (s1) transmitted into the absorber and a wave (R) reflected from the surface of the composite sheet layer 300 depending on the properties of the composite sheet layer 300 (e.g., content, morphology, inherent electrical conductivity, and surface condition of the conductive powder dispersed in the sheet layer).

For example, an electromagnetic wave, when incident on the electromagnetic wave absorber 400, is partially absorbed into the support layer 200, working as a first internal wave (s1), while the remnant wave (R) is reflected from the composite sheet layer 300, depending on the property of the composite sheet layer 300.

In addition, the first internal wave (s1) is reflected from the highly conductive backing layer 100 and is then incident on the composite sheet layer 300 to produce a second internal wave (s2), while the remnant wave (e1), which results from the subtraction of the second internal wave from the first internal wave (s1), is transmitted through the composite sheet layer 300 and dissipated into air.

The second internal wave (s2) is again reflected from the highly conductive backing layer 100 and is then incident on the composite sheet layer to produce a third internal wave (s3), while the remnant wave (e2), which results from the subtraction of the third internal wave (s3) from the second internal wave (s2), is transmitted through the composite sheet layer 300 and dissipated into air.

In this manner, an N-1$^{th}$ internal wave (sN-1) is reflected from the highly conductive backing layer 100 and is incident on the composite sheet layer 300 to produce an N$^{th}$ internal wave (sN), while the remnant wave (eN-1), which results from the subtraction of the N$^{th}$ internal wave from the N-1$^{th}$ wave (sN-1), is transmitted through the composite sheet layer 300 and dissipated into air.

Accordingly, total reflected wave from the electromagnetic wave absorber 400 can be represented by R- (e1 + e2 + e3 + ... + eN- 1) (N is a natural number).

In the electromagnetic wave absorber, the matching is observed when R - (e1 + e2 + e3 + ... + eN-1) = 0 (= -∞ dB).

In one embodiment of the present invention, the composite sheet layer 300 may contain a carbon nanomaterial such as carbon black (CB), carbon nanotubes (CNT), or carbon nanofibers (CNF), and may exhibit various complex permittivities depending on the material (J.B. Kim and C.G. Kim, Composite Science and Technology, 70, 2010, 1748-1754). The highly conductive backing layer 100 may be in the form of a metal thin film.

FIG. 6 is a graph in which the complex permittivity of a 0.2 mm-thick dielectric lossy composite sheet layer, necessary for the matching in an electromagnetic wave absorber with a center frequency of 10 GHz designed to have a glass fiber-reinforced epoxy laminate as a support layer for the composite sheet layer, is plotted according to the thickness of the glass fiber/epoxy laminate.

As is understood from the plot of FIG. 6, an increase in the thickness of the support layer causes the complex permittivity of the dielectric lossy composite sheet layer to be greatly reduced in the real part (ε') and slightly reduced in

the imaginary part ($\varepsilon''$).

When the glass fiber/epoxy laminate (dielectric constant: 4.659-j0.171) is applied to a conventional Salisbury screen-type absorber shown in FIG. 3, it may be 3.448 mm in thickness according to Math Formula 2. As shown in FIG. 5, when the thickness of the support layer is 3.448 mm, the real part ($\varepsilon'$) of complex permittivity becomes 1 with the imaginary part ($\varepsilon''$) converging on 22.394.

In consideration of the thickness (0.2 mm) of the composite sheet with a center frequency of 10 GHz, the imaginary part ($\varepsilon''$) of complex permittivity of 22.394 corresponds to a sheet resistance of 377 $\Omega$/sq according to the following Math Formula 3.

[Math Formula 3]

$$R_s = 1/(d_{sheet} \times \sigma_{ac}) = 1/(d_{sheet} \times 2\pi f_{center} \varepsilon_0 \varepsilon'')$$

$R_s$: sheet resistance [$\Omega$/sq]

$d_{sheet}$: thickness of sheet [m]

$\sigma_{ac}$: alternating current electrical conductivity of sheet [S/m]

$f_{center}$: center frequency of electromagnetic wave absorber [Hz]

$\varepsilon_0$: absolute dielectric constant of air ($8.854 \times 10^{-12}$ F/m)

When recruited in the conventional Salisbury screen type absorber of FIG. 3, as is apparent from the result obtained above, the dielectric lossy composite sheet layer with complex permittivity according to the present invention has an advantage over a resistive sheet with sheet resistance of 377 $\Omega$/sq in reducing the thickness of the support layer. Particularly, a higher real part ($\varepsilon'$) of complex permittivity is observed to make a greater contribution to a reduction in the thickness of the support layer.

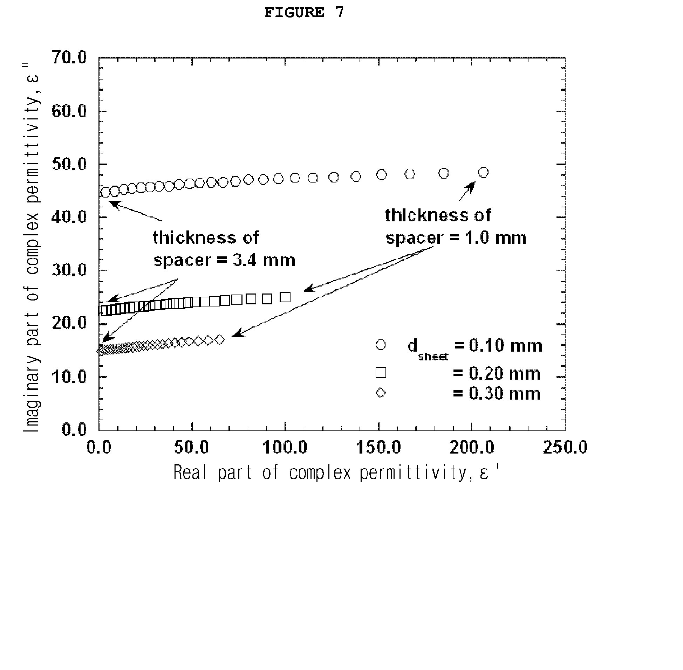

FIG. 7 is a graph showing the complex permittivity of the dielectric lossy composite sheet layer of FIG. 5 according to thickness.

As can be seen in FIG. 7, a thinner sheet requires a higher imaginary part ($\varepsilon''$) of the complex permittivity.

These results indicate that the thickness and complex permittivity of the dielectric lossy composite of the present invention can be properly selected depending on the center frequency of the electromagnetic wave absorber, and the thickness and dielectric constant of the support layer.

In the present invention, test samples made of an epoxy resin with various contents of carbon black (CB), carbon nanofibers (CNF), and carbon nanotubes (MWNT) were evaluated for electromagnetic properties.

In Examples, HG-1P of LINZI HUAGUANG Chemical Ind. (China) was used as carbon black (CB), PYROGRAF III (PR-19-XT-LHT) of APPLIED SCIENCE Inc. (USA) was used as carbon nanofibers (CNF), and CM-95 of ILJIN NANOTECH Co. Ltd. (Korea) was used as carbon nanotubes (MWNT).

The composite 300 is layered on the glass fiber fabric/epoxy laminate.

In detail, the composite 300 is formed by applying an epoxy resin in which carbon black (CB), carbon nanofibers (CNF), or carbon nanotubes (MWNT) are homogenously dispersed to a glass fiber fabric.

The glass fiber fabric may be a plain weave fabric which is slightly different in fiber count between fill and warp directions, and may be, for example, an insulation mat for #110 PCB, manufactured by HANKUK Fiber, which has small cells and is thin.

The epoxy resin is based on a bisphenol-A type resin with an aromatic amine-type curing agent plus a diluent for easy application to a fabric, and a small amount of a reaction accelerator.

As for the weight of the carbon material on the basis of the total weight of the epoxy free of the diluent, it may amount to 5.19 wt % for carbon black, 2.11 wt % for carbon nanofibers, and 4.71 wt % for carbon nanotubes. The composite sheet layer has an R/C (resin content) of about 50 %.

In addition, one glass fiber fabric sheet with a dimension of 100 mm in both warp and fill directions, was stacked upon another, and autoclaved for each carbon material.

The absorber 400 may be fabricated with a thermal cycle of 80°C for 30 min and 125°C for 90 min under a pressure of 6 Torr. After fabrication, the composite sheet layers containing carbon black (CB), carbon nanofibers (CNF), and carbon nanotubes (MWNT) were measured to be 0.250 mm, 0.275 mm, and 0.252 mm thick, respectively.

Before being applied to the fabrication of the electromagnetic wave absorber 400, the three composite sheet layers 300 were measured for complex permittivity and complex permeability. Because the carbon materials are electrically conductive, the composite sheet layer exhibits a complex permeability of 1. The complex permittivity of the composite was measured using the vector network analyzer Agilent N5230A, and a 7 mm coaxial tube.

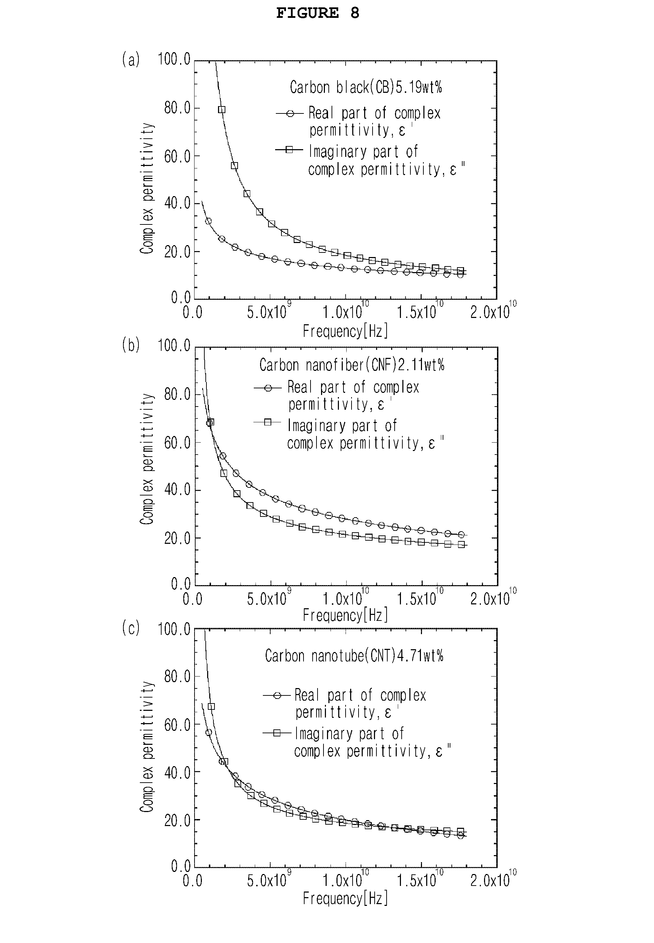

FIG. 8 shows plots of the complex permittivity of composite sheet layers containing carbon black, carbon nanofibers, and carbon nanotubes as conductive powders, respectively.

In FIG. 8a, the complex permittivity of a dielectric lossy composite sheet layer containing carbon black (CB) is plotted against frequency.

FIG. 8b shows the complex permittivity of a dielectric lossy composite sheet layer containing carbon nanofibers (CNF) as a function of frequency.

In FIG. 8c, the complex permittivity of a dielectric lossy composite sheet layer containing carbon nanotubes (MWNT) is shown as a function of frequency.

In this context, the dielectric lossy composite sheet layer may contain carbon black (CB) in an amount of 5.19 wt %, carbon nanofibers (CNF) in an amount of 2.11 wt %, or carbon nanotubes (MWNT) in an amount of 4.71 wt %, respectively.

Turning to FIG. 8, the complex permittivity (real part and imaginary part) of the composite sheet layer is observed to depend on the kind and content of the compounds used in the sheet layer (e.g., carbon black, carbon nanofibers, and carbon nanotubes), and the frequency of the sheet layer.

A glass fiber/epoxy composite laminate (dielectric constant: 4.659-j0.171) was used as a support layer for electromagnetic wave absorbers recruiting one of the three composite sheet layers described above.

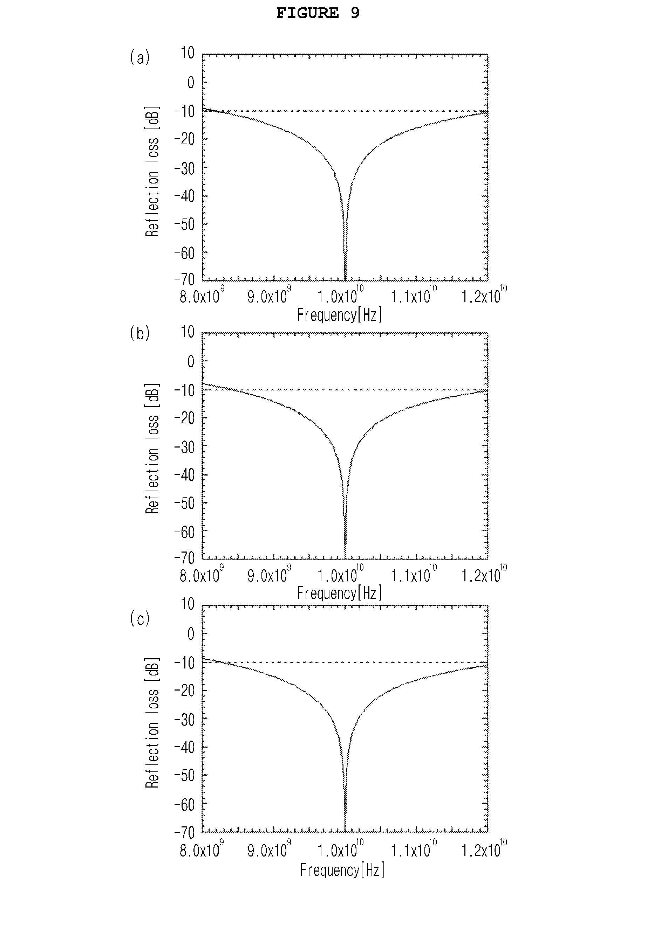

FIG. 9 shows graphs in which reflection losses of the composite sheet layers containing carbon black, carbon nanofibers, and carbon nanotubes as conductive powders, respectively, are plotted against frequency.

FIG. 9a is a plot of the reflection loss of the composite layer containing carbon black against frequency.

FIG. 9b is a plot of the reflection loss of the composite layer containing carbon nanofibers against frequency.

FIG. 9c is a plot of the reflection loss of the composite layer containing carbon nanotubes against frequency.

Considering the data given in FIGS. 9a to 9c, the electromagnetic wave absorbers with a center frequency of 10 GHz, respectively fabricated with the three composite sheet layers, exhibit the following electromagnetic wave absorption performance.

With reference to the reflection loss graph of FIG. 9a, the composite sheet layer containing carbon black as a conductive powder exhibits a complex permittivity ($\varepsilon$) of 13.127-j18.502 with a -10 dB bandwidth of 3.98 GHz.

With reference to the reflection loss graph of FIG. 9a, the composite sheet layer containing carbon nanofibers as a conductive powder exhibits a complex permittivity ($\varepsilon$) of 27.967-j21.448 with a -10 dB bandwidth of 3.72 GHz.

With reference to the reflection loss graph of FIG. 9c, the composite sheet layer containing carbon nanotubes as a conductive powder exhibits a complex permittivity ($\varepsilon$) of 19.948-j18.628 with a -10 dB bandwidth of 4.10 GHz.

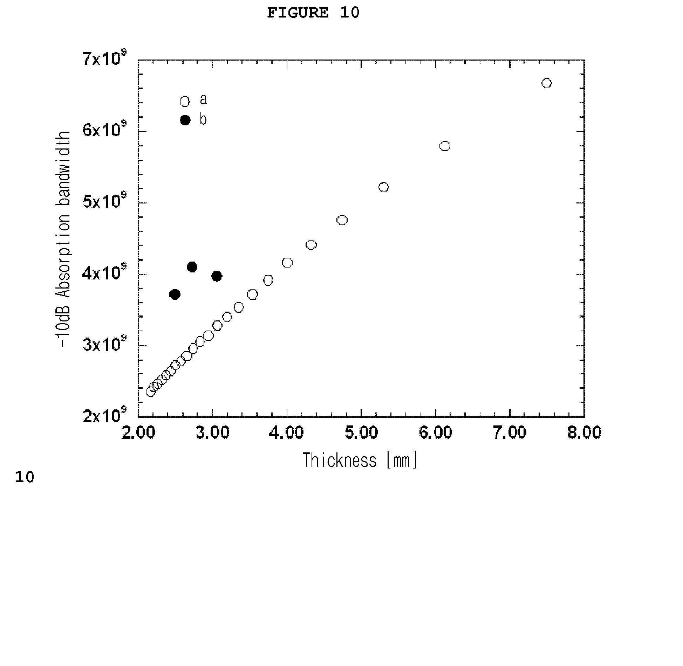

FIG. 10 is a graph in which -10 dB bandwidths of the electromagnetic wave absorbers shown in FIG. 5 of the present invention (a) and in FIG. 3 (b) are plotted against thickness.

As can be seen in FIG. 10, the electromagnetic wave absorber (a) of the present invention is structurally similar to the conventional Salisbury screen-type electromagnetic wave absorber (b) of FIG. 3, but exhibits a broader absorption bandwidth over thicknesses.

In full consideration of the data shown in FIGS. 5 to 9, the present invention envisages a method for the fabrication of an electromagnetic wave absorber, comprising: providing a dielectric support layer for a resonant space of electromagnetic waves; assigning a highly conductive backing layer to a back surface of the dielectric support layer; and forming a dielectric lossy composite sheet layer on a front surface of the dielectric support layer, said dielectric lossy composite sheet layer having such a complex permittivity so as to generate a resonant peak with an electromagnetic wave reflected from the highly conductive backing layer. The electromagnetic wave absorber fabricated using the method of the present invention exhibits a broad absorption bandwidth with a relatively narrow matching thickness of the support layer while retaining the methodological and structural advantages of a conventional Salisbury screen-type absorber.

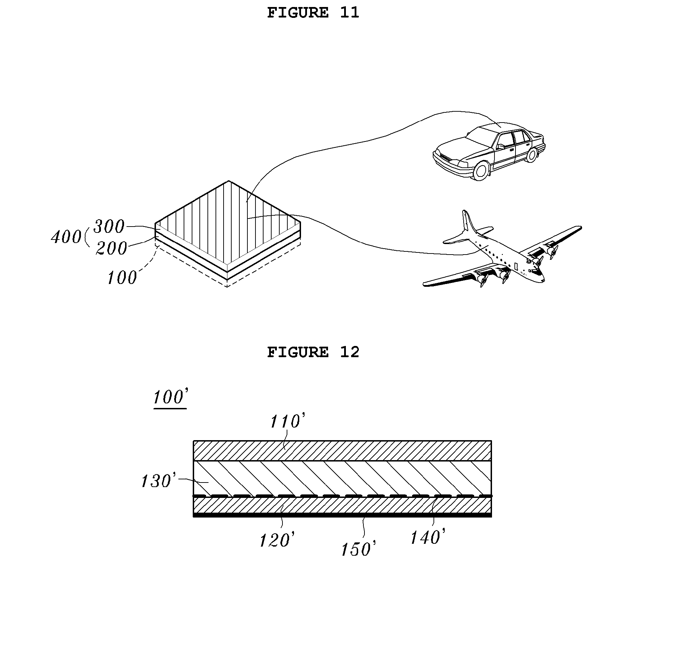

FIG. 11 is a schematic view illustrating the application of the electromagnetic wave absorber of FIG. 5 to general structures.

In addition, the electromagnetic wave absorber of the present invention comprises a dielectric support layer for providing a resonant space of electromagnetic waves, a highly conductive backing layer assigned to a back surface of the dielectric support layer, and a dielectric lossy composite sheet layer formed on a front surface of the dielectric support layer, said dielectric lossy composite sheet layer having such a dielectric permittivity so as to generate a resonant peak with the electromagnetic waves reflected from the highly conductive backing layer.

If a structure has as its surface a material that reflects more than 90 % of electromagnetic waves incident thereon, like a metal or a carbon fiber-reinforced composite, the surface may be used as the backing layer 100 of the electromagnetic wave absorber of the present invention. When the surface of a certain structure reflects electromagnetic waves at a rate of less than 90 %, a thin metal film may be employed as a highly conductive backing layer 100 between the surface of the structure and the support layer 200.

As shown in FIG. 11, the electromagnetic wave absorber applicable to general targets having a metal layer as its surface may be fabricated into a structure consisting of the dielectric support layer and the composite sheet layer.

Therefore, the electromagnetic wave absorber of the present invention finds applications in various structures having a highly conductive surface, such as a car, an aircraft, a ship, a wireless communication device, a railroad train, a wind turbine, a mobile communication device, etc.

Further, the electromagnetic wave absorber of the present invention may be fabricated into a form which is readily attachable to a preexisting structure. For example, the electromagnetic wave absorber, when applied to a ship, may be in a rectangular form (e.g., tile form) .

In the case of large vessels or aircrafts, which are typically manufactured using an assembly process, their surface designed to absorb electromagnetic waves requires an additional process in the manufacture, giving rise to an increase in production cost.

However, the electromagnetic wave absorber of the present invention allows a process for electromagnetic wave shielding or absorption, which has been incorporated into the manufacture of a structure, to be separated from the manufacture process, and can be readily applied to a ready- made structure having a highly conductive surface, thus exerting an excellent effect in terms of production cost.

The structure to which the electromagnetic wave absorber of the present invention is applied increases biocompatibility between electromagnetic devices in high-frequency bands, and enhances the reliability of wireless communication against electromagnetic wave environments.

Embodiments described above are only exemplary of the technical spirit of the present invention, and thus, those skilled in the art can make selective modifications on conditions for fabrication processes, such as temperatures, time, polymer resin, and kind and volume fraction of conductive powders (inclusive of fibers).

FIG. 12 is a cross-sectional view of an airfoil upper or lower plate for wind turbine blades, provided with a function of electromagnetic wave absorption in accordance with an embodiment of the present invention.

As shown in FIG. 12, the wind turbine blades provided with a function of electromagnetic wave absorption in accordance with an embodiment of the present invention comprises a composite, an electromagnetic wave-absorbing screen 150', and a resin-permeable, highly conductive backing layer 140'.

The composite is a sandwich structure composed of an internal face layer 110', a core 130', and an external face layer 120'. In the sandwich structure, the internal face layer and the external face layer may be made of a glass fiber-reinforced composite, while the core may consist of a non-conductive dielectric, such as a foam or balsa wood.

In detail, the glass fiber-reinforced composite used for both the internal and external face layers was a 4-ply laminate of the [±45] bi-axial NCF fabric (SAERTEX GmbH & Co. of German) reinforced with SE1500 glass fibers (OWENS CORNING), while the non-conductive dielectric used as the core was AIREX PVC foam (ALCAN, USA). When a 4-ply laminate of the [±45] bi-axial NCF fabric manufactured by SAERTEX GmbH & Co. is used as each of the internal and external face layers, it may have a thickness of 2.15 mm.

The electromagnetic wave-absorbing screen 150' is located below the external face layer 120', and may be in a form selected from the group consisting of a dielectric lossy composite sheet, a resistive sheet with a sheet resistance of 377 $\Omega$/sq, or a circuit analog.

An epoxy resin in which a carbon nanomaterial is homogenously dispersed may be applied to a glass fiber fabric to form the electromagnetic screen. The carbon nanomaterial may be selected from carbon black, carbon nanofibers, carbon nanotubes, and a combination thereof.

In detail, the electromagnetic wave absorbing screen of the present invention may be made of an epoxy resin with various contents of carbon black (CB) , carbon nanofibers (CNF) , or carbon nanotubes (MWNT) , and may be evaluated for electromagnetic properties. In the present invention, HG- 1P of LINZI HUAGUANG Chemical Ind. (China) was used as carbon black (CB) , PYROGRAF III (PR- 19- XT- LHT) of APPLIED SCIENCE Inc. (USA) was used as carbon nanofibers (CNF) , and CM- 95 of ILJIN NANOTECH Co. Ltd. (Korea) was used as carbon nanotubes (MWNT) .

The glass fiber fabric may be a plain weave fabric which is slightly different in fiber count between fill and warp directions, and may be, for example, an insulation mat for #110 PCB, manufactured by HANKUK Fiber, which has small cells and is thin.

In addition, the epoxy resin is based on a bisphenol-A type resin with an aromatic amine type curing agent plus a diluent for easy application to a fabric, and a small amount of a reaction accelerator. The weight percentages of the carbon nanomaterials used in the resin ware 5.30 wt % for carbon black, 2.08 wt % for carbon nanofibers, and 4.78 wt % for carbon nanotubes. The weight percentages of the carbon nanomaterials were based on the total weight of the epoxy resin exclusive of the weight of the diluent. The resin content in the electromagnetic wave-absorbing screen was about 50 %.

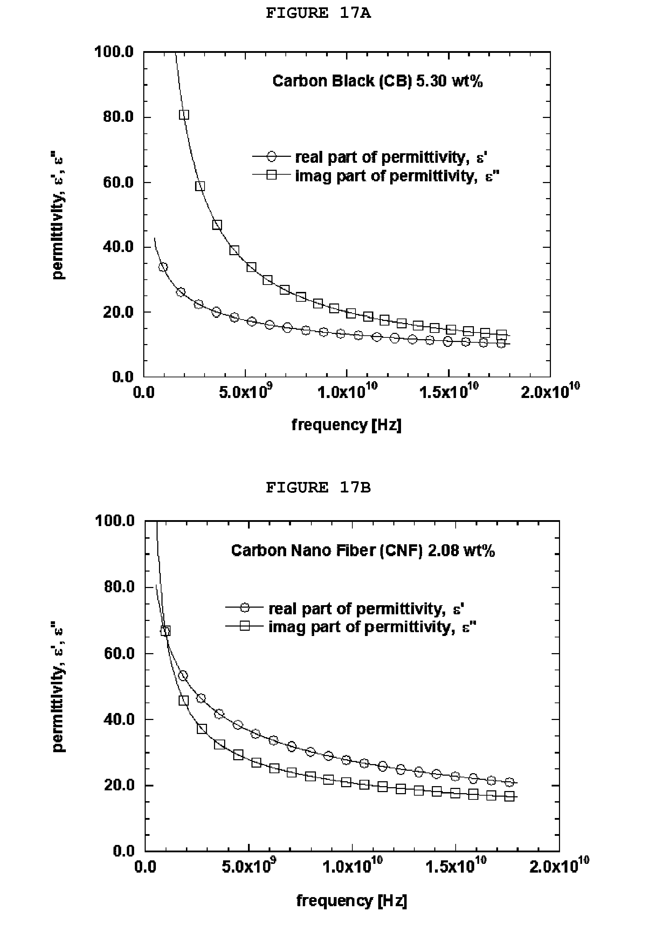

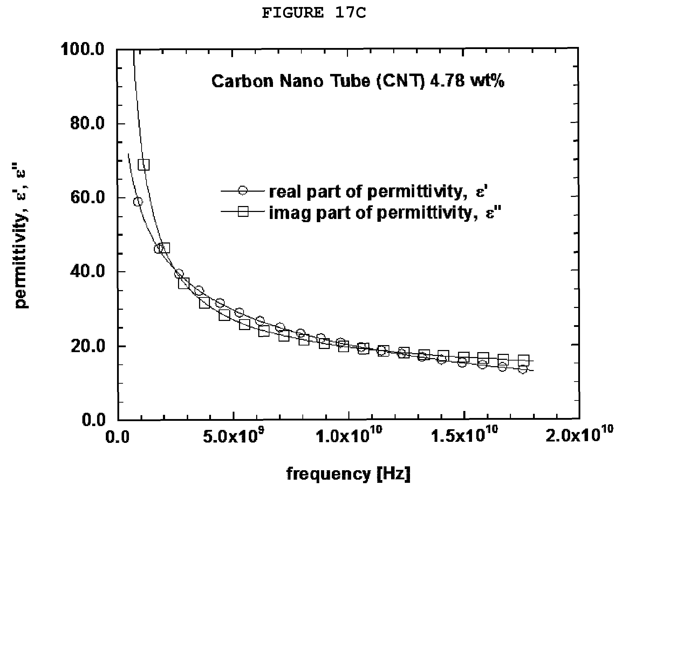

With reference to FIGS. 17a to 17c, there are plots of the complex permittivity of dielectric lossy electromagnetic wave-absorbing screens

Further, the electromagnetic wave- absorbing screens were measured for complex permittivity and complex permeability.

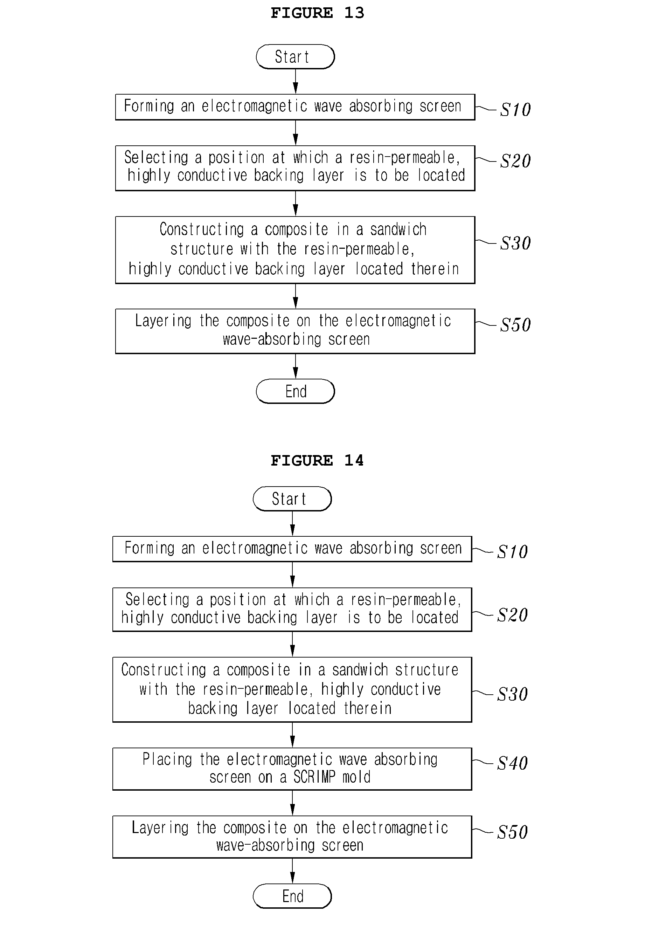

Because the carbon materials are electrically conductive, the electromagnetic wave-absorbing screen exhibits a complex permeability of 1. The complex permittivity of the composite was measured using the vector network analyzer Agilent N5230A, and a 7 mm coaxial tube. The results are the same as given in FIGS. 13a to 13c which show the complex permittivity of the dielectric lossy electromagnetic wave-absorbing screens containing carbon black, carbon nanofibers, and carbon nanotubes, respectively.

The resin-permeable, highly conductive backing layer 140' may be inserted into the composite 100' of the sandwich structure, functioning to reflect electromagnetic waves. The resin-permeable, highly conductive backing layer 140' can be formed of at least one carbon fiber fabric laminate.

By way of examples, the resin-permeable, highly conductive backing layer 140' may be inserted into the external face layer 120', between the external face layer 120' and the core 130', or into the core 130'. When the resin-permeable, highly conductive backing layer is inserted into the core, it may be located at a certain position in the  thickness direction of the core, allowing the matching of the electromagnetic wave absorber.

A carbon fabric is a material which is widely used, together with glass fiber, for high-performance composite structures such as composite airfoil blades. In the present invention, the backing layer is made of WSN3K (FAW = 195 g/m$^2$, thickness = 0.223 mm) of SK Chemicals, Korea, which is weaved on the basis of TR30 (Mitsubishi, Japan).

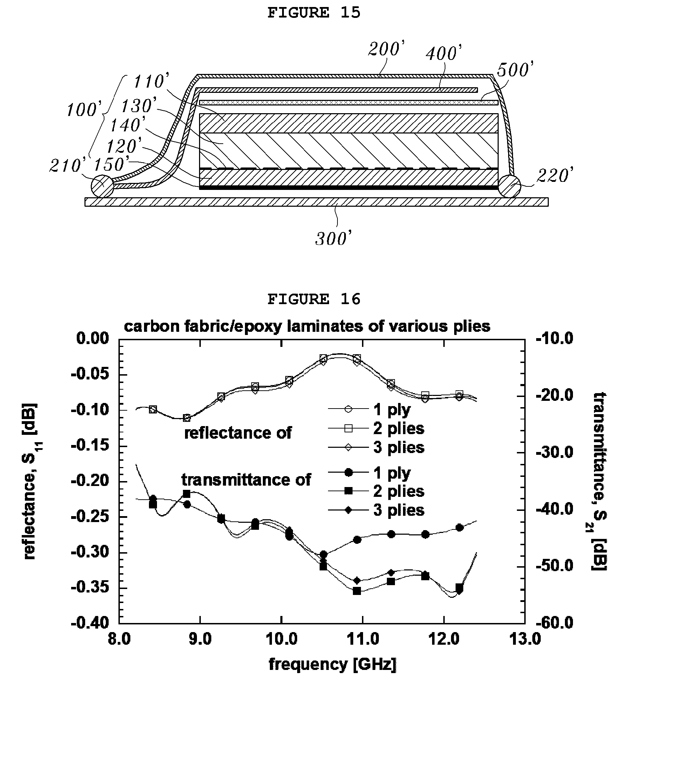

FIG. 16 is a graph showing electromagnetic wave reflectance and transmittance properties of carbon fabrics for use in the highly conductive backing layer.

In this regard, an epoxy resin-permeable, 1-, 2- or 3-ply WSN3k laminate was evaluated for utility as the highly conductive backing layer by measuring its electromagnetic wave reflectance and transmittance in X-band (8.2 GHz ~ 12.4 GHz) with an HVS Free Space Measurement System.

Given a maximal reflection loss of -0.1 dB, a carbon fiber fabric exhibits a reflectance of at least 98 %. As shown in FIG. 12, almost the same patterns as this reflectance property are observed in highly conductive backing layers whether consisting of 1, 2, or 3 plies of a carbon fiber fabric. Therefore, one ply of a carbon fabric was employed as a material for the highly conductive backing layer.

In practice, a substance with reflectance of about 95 % or higher can serve as a backing layer. Preferably, the resin-permeable backing layer has electromagnetic wave reflectance of at least 95 % or higher.

Meanwhile, when a liquid resin flows through a certain medium, the flow rate of the liquid resin can be represented by the following Math Formula 4.

[Math Formula 4]

$$U = \frac{K}{\mu} \frac{\delta p}{\delta x}$$

(U: flow rate [m/s] , K: permeability coefficient of medium [m$^2$] , $\delta$p/ $\delta$x: pressure gradient in thickness direction [N/m$^3$] , $\mu$ : viscosity [N·s/ m$^2$] )

In this regard, the resin-permeable, highly conductive backing layer may have a permeability coefficient of $10^{-6}$ ~ $10^{14}$ m$^2$ against the flow of liquid resin in the thickness direction.

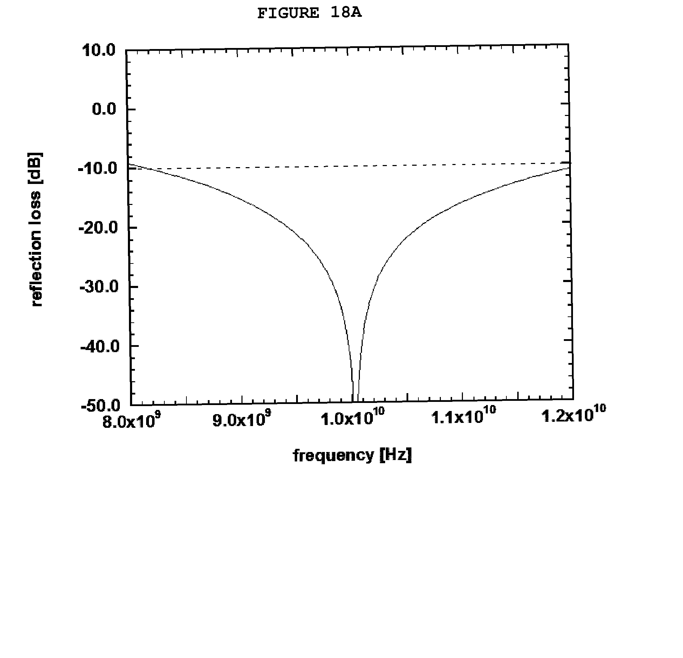

FIGS. 18a to 18c are reflection loss graphs showing the absorption performance of wind turbine blades fabricated with the dielectric lossy, electromagnetic wave absorbing screen.

The electromagnetic wave absorption performances of wind turbine blades fabricated in accordance with one embodiment of the present invention are shown in FIGS. 18a to 18c.

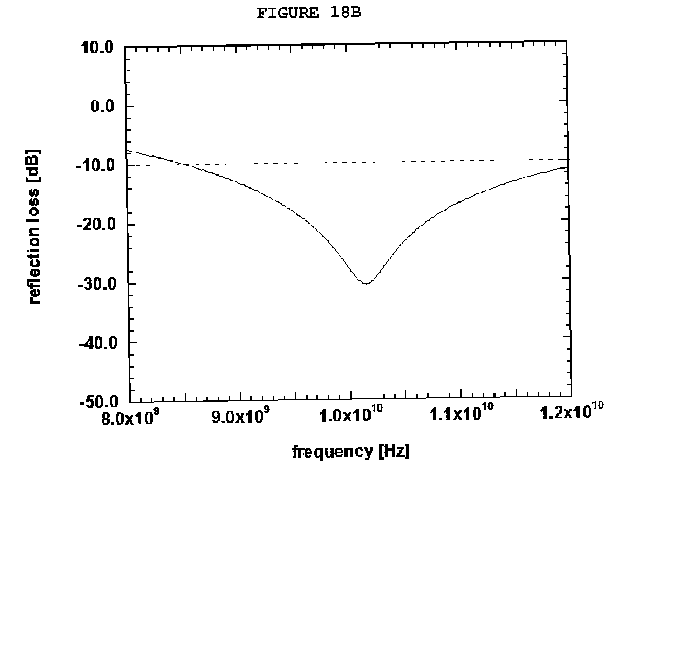

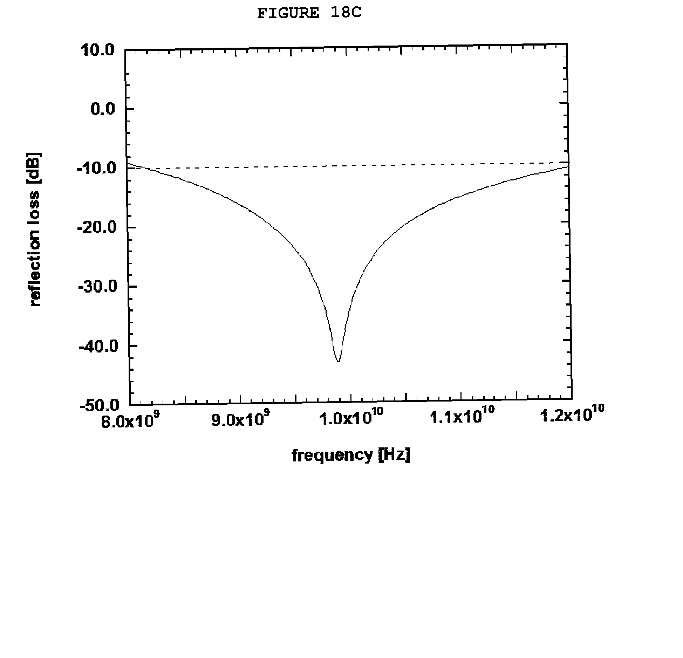

In detail, FIG. 18a shows the electromagnetic wave absorption performance of a wind turbine blade in which a carbon fiber fabric backing layer employing carbon black as a  conductive powder is located at a position 0.7 mm deep toward the core from the border between the core and the external face layer of the composite. FIG. 18b shows the electromagnetic wave absorption performance of a wind turbine blade in which a carbon fiber fabric backing layer employing carbon nanofibers as a conductive powder is located at the border between the core and the external face layer of the composite. FIG. 18c shows the electromagnetic wave absorption performance of a wind turbine blade in which a carbon fiber fabric backing layer employing carbon black as a conductive powder is located at a position 0.4 mm deep toward the core from the border between the core and the external face layer of the composite.

Below, a detailed description will be given of a method for fabricating a wind turbine blade having an electromagnetic wave absorbing function in accordance with the present invention.

With reference to FIG. 13, a block diagram illustrating a method for fabricating a wind turbine blade having an electromagnetic wave absorbing function in accordance with an embodiment of the present invention is shown.

As shown in FIG. 13, the method for fabricating a wind turbine blade having an electromagnetic wave absorbing function in accordance with an embodiment of the present invention comprises forming an electromagnetic wave absorbing  screen (S10), selecting a position at which a resin-permeable, highly conductive backing layer is to be located (S20), constructing a composite in a sandwich structure with the resin-permeable, highly conductive backing layer located therein (S30), and layering the composite on the electromagnetic wave-absorbing screen (S50).

In the forming step (S10), an epoxy resin in which a carbon nanomaterial is homogeneously dispersed is applied to a glass fiber fabric to form an electromagnetic wave absorbing screen.

The selecting step (S20) is to select a position at which a carbon fiber fabric, used as a resin-permeable, highly conductive backing layer, is located in a composite in a sandwich structure.

In the selecting step (S20), the resin-permeable, highly conductive backing layer 140 may be determined to be inserted into the external face layer, between the external face layer and the core, or into the core of the composite such that matching is achieved in the electromagnetic wave absorber.

When the resin-permeable, highly conductive backing layer is inserted into the core, any position in the thickness direction may be preferably suitable for generating the matching of the electromagnetic wave absorber.

In the constructing step (S30), an internal face layer, a core, and an external face layer are laminated, together with the resin-permeable, highly conductive backing layer, in that order to form a sandwich-type composite with the resin-permeable, highly conductive backing layer embedded therein.

Constitutional elements and structures of the reinpermeable, highly conductive backing layer, the electromagnetic wave absorbing screen, and the sandwich-type composite in the method are the same as are described in the wind turbine blade having an electromagnetic wave absorbing function, and thus a description is omitted herein.

FIG. 15 is a schematic cross-sectional view of the structure of a wind turbine blade having an electromagnetic wave absorbing function in accordance with one embodiment of the present invention when elements are arranged using SCRIMP.

In the layering step (S50), as shown in FIG. 13, the composition in a sandwich structure is placed on a screen which is formed by coating a glass fiber fabric with a carbon nanomaterial-dispersed epoxy resin.

FIG. 14 is a block diagram illustrating a method for fabricating a wind turbine blade having an electromagnetic wave absorbing function in accordance with another embodiment of the present invention.

The method for fabricating a wind turbine blade having an electromagnetic wave absorbing function in accordance with another embodiment of the present invention, as shown in FIG. 14, may further comprise placing the electromagnetic wave absorbing screen on a SCRIMP mold (S40) after the step of constructing the sandwich-type composite employing the resin-permeable, highly conductive backing layer (S30).

The placing step (S40), as shown in FIG. 14, is used to bring the electromagnetic wave-absorbing screen 150 into contact with the SCRIMP mold 300.

As described hitherto, the present invention provides a wind turbine blade having an electromagnetic wave function, and a method for the fabrication thereof, in which a dielectric material used in a wind turbine blade is employed as a support layer for an electromagnetic wave absorber to allow the avoidance of radar interference without requiring an additional absorber, thus reducing a burden on production cost, fabrication time, and maintenance.

While the present invention has been particularly shown and described with reference to the foregoing preferred and alternative embodiments, it should be understood by those skilled in the art that various alternatives to the embodiments of the invention described herein may be employed in practicing the invention without departing from the spirit and scope of the invention as defined in the following claims. It is intended that the following claims define the scope of the invention and that the method and absorber within the scope of these claims and their equivalents be covered thereby. This description of the invention should be understood to include all novel and non-obvious combinations of elements described herein, and claims may be presented in this or a later application to any novel and non-obvious combination of these elements. The foregoing embodiments are illustrative, and no single feature or element is essential to all possible combinations that may be claimed in this or a later application.

<Description of the Reference Numerals in the Drawings>

100: highly conductive backing layer 100': composite
110': internal face layer 120': external face layer
130': core 140': resin-permeable, highly conductive backing layer
150': electromagnetic wave absorbing screen 200': vacuum bag
200: support layer 210': resin inlet
220': vacuum outlet 300': mold
300: composite sheet layer
400: electromagnetic wave absorber
400': resin flow material
500': resin-permeable, releasable film

**Claims**

1.  An electromagnetic wave absorber, comprising:

    a support layer for providing a resonant space of electromagnetic waves;
    a highly conductive backing layer assigned to a back surface of the dielectric support layer; and
    a dielectric lossy composite sheet layer formed on a front surface of the dielectric support layer, said dielectric lossy composite sheet layer having such a dielectric permittivity so as to generate a resonant peak with the electromagnetic waves reflected from the highly conductive backing layer.

2.  The electromagnetic wave absorber of claim 1, wherein the dielectric lossy composite sheet layer comprises a polymer matrix with a conductive powder dispersed therein, and exhibits complex permittivity.

3.  The electromagnetic wave absorber of claim 2, wherein the complex permittivity varies depending on a factor selected from the group consisting of content, morphology, inherent electrical conductivity, and surface condition of the dispersed conductive powder.

4.  The electromagnetic wave absorber of claim 1, wherein the complex permittivity varies depending on a thickness of the composite sheet layer.

5.  The electromagnetic wave absorber of claim 1, wherein the complex permittivity varies depending on a center frequency of the absorber, and a thickness of the support layer.

6.  The electromagnetic wave absorber of claim 1, wherein the complex permittivity has a real part of greater than 1.

7.  The electromagnetic wave absorber of claim 1, wherein the composite sheet layer is formed by applying an epoxy resin in which carbon black, carbon nanofibers, or carbon nanotubes are homogeneously dispersed to a glass fiber fabric.

8.  The electromagnetic wave absorber of claim 1, wherein the composite sheet layer comprises a carbon nanomaterial.

9.  The electromagnetic wave absorber of claim 7, wherein the glass fiber fabric is a plain weave fabric which has small cells and is slightly different in fiber count between fill and warp directions, and which is used as a thin PCB insulation mat.

10. An electromagnetic wave absorber, comprising:

    a support layer for providing a resonant space of electromagnetic waves;
    a highly conductive backing layer assigned to a back surface of the dielectric support layer; and
    a multi-ply composite sheet layer formed on the dielectric support layer, said multi-ply composite sheet layer having such a dielectric permittivity so as to generate a resonant peak with the electromagnetic waves reflected from the highly conductive backing layer.

11. The electromagnetic wave absorber of claim 13, wherein at least one ply of the multi-ply composite sheet layer is formed by coating a glass fiber fabric with an epoxy resin in which carbon black, carbon nanofibers, or carbon nanotubes are homogenously dispersed.

12. A method for fabricating an electromagnetic wave absorber, comprising:

    providing a dielectric support layer for a resonant space of electromagnetic waves;
    assigning a highly conductive backing layer to a back surface of the dielectric support layer; and
    forming a dielectric lossy composite sheet layer on a front surface of the dielectric support layer, said dielectric lossy composite sheet layer having such a complex permittivity so as to generate a resonant peak with an electromagnetic wave reflected from the highly conductive backing layer.

13. The method of claim 12, wherein the dielectric lossy composite sheet layer is formed in such a way that conductive powders are homogenously dispersed in a polymer matrix to endow the dielectric lossy composite sheet layer with complex permittivity.

14. The method of claim 12, wherein the complex permittivity varies depending on a factor selected from the group consisting of content, morphology, inherent electrical conductivity, and surface condition of the dispersed conductive powder.

15. The method of claim 12, wherein the complex permittivity varies depending on a thickness of the composite sheet layer.

16. The method of claim 12, wherein the complex permittivity varies depending on a center frequency of the absorber and a thickness of the support layer.

17. The method of claim 12, wherein the thickness of the composite sheet layer varies depending on a center frequency of the absorber and a thickness of the support layer.

18. The method of claim 12, wherein the complex permittivity consists of a real part (e') and an imaginary part (e"), and exceeds 1.

19. The method of claim 12, wherein the composite sheet layer is formed by coating a glass fiber fabric with an epoxy resin in which carbon black, carbon nanofibers, or carbon nanotubes are homogenously dispersed.

20. The method of claim 17, wherein the composite sheet layer comprises a carbon nanomaterial.

21. The method of claim 19, wherein the glass fiber fabric is a plain weave fabric which has small cells and is slightly different in fiber count between fill and warp directions, and which is used as a thin PCB insulation mat.

22. The method of claim 19, wherein the epoxy resin is based on a bisphenol-A type resin with an aromatic amine-type curing agent plus a diluent for easy application to a fabric, and a small amount of a reaction accelerator.

23. A wind turbine blade, comprising:

   a composite in a sandwich structure consisting of an internal face layer, a core, and an external face layer;
   an electromagnetic wave absorbing screen located below the external face layer; and
   a resin-permeable, highly conductive backing layer inserted into the sandwich-type composite, functioning to reflect electromagnetic waves.

24. The wind turbine blade of claim 23, wherein the electromagnetic wave absorbing screen is formed by coating a glass fiber fabric with an epoxy resin in which a carbon nanomaterial is homogeneously dispersed.

25. The wind turbine blade of claim 24, wherein the carbon nanomaterial is selected from the group consisting of carbon black, carbon nanofibers, carbon nanotubes, and a combination thereof.

26. The wind turbine blade of claim 23, wherein the electromagnetic wave absorbing screen is selected from the group consisting of a dielectric lossy composite sheet, a resistive sheet with sheet resistance of 377 $\Omega$/sq, and a circuit analog.

27. The wind turbine blade of claim 23, wherein the resin-permeable, highly conductive backing layer is formed by stacking at least one carbon fabric.

28. The wind turbine blade of claim 23, wherein the resin-permeable highly conductive backing layer is inserted into the external face layer, between the external face layer and the core, or into the core.

29. The wind turbine blade of claim 28, wherein the resin-permeable highly conductive backing layer is located at any position in a thickness direction within the core.

30. The wind turbine blade of claim 23, wherein the resin-permeable, highly conductive backing layer has a permeability coefficient of $10^{-6} \sim 10^{-14}$ m$^2$ against a flow of a liquid resin in a thickness direction, as calculated according to the following Math Formula:

$$U = \frac{K}{\mu} \frac{\delta p}{\delta x}$$

(U: flow rate [m/s], K: permeability coefficient of medium [$m^2$], $\delta p/\delta x$: pressure gradient in thickness direction [N/$m^2$], p: viscosity [N·s/$m^2$]).

31. The wind turbine blade of claim 23, wherein the resin-permeable, highly conductive backing layer has electromagnetic wave reflectivity of 95 %.

32. The wind turbine blade of claim 23, wherein the composite in a sandwich structure comprises an internal face layer, an external face layer, and a core sandwiched therebetween, both said internal face layer and said external face layer being made of a glass fiber-reinforced composite, and said core being made of a non-conductive dielectric selected from the group consisting of a foam and balsa wood.

33. A method for fabricating a wind turbine blade having an electromagnetic wave absorbing function, comprising:

forming an electromagnetic wave absorbing screen by coating a glass fiber fabric with an epoxy resin in which a carbon nanomaterial is homogeneously dispersed;
selecting a position at which a resin-permeable, highly conductive backing layer is to be located;
constructing a composite in a sandwich structure with the resin-permeable, highly conductive backing layer located therein by laminating an internal face layer, a core, and an external face layer in that order; and
layering the composite on the electromagnetic wave-absorbing screen.

34. The method of claim 33, further comprising placing the electromagnetic wave absorbing screen on a mold.

35. The method of claim 33 or 34, wherein the selecting is carried out by inserting the resin-permeable highly conductive backing layer into the external face layer, between the external face layer and the core, or into the core.

36. The method of claim 35, wherein the resin-permeable highly conductive backing layer is inserted into the core at any position in a thickness direct of the core.

## FIGURE 1

## FIGURE 2

**FIGURE 3**

**FIGURE 4**

FIGURE 5

FIGURE 6

FIGURE 7

## FIGURE 8

(a)

Carbon black(CB)5.19wt%
—⊖— Real part of complex permittivity, ε'
—⊟— Imaginary part of complex permittivity, ε"

(b)

Carbon nanofiber(CNF)2.11wt%
—⊖— Real part of complex permittivity, ε'
—⊟— Imaginary part of complex permittivity, ε"

(c)

Carbon nanotube(CNT)4.71wt%
—⊖— Real part of complex permittivity, ε'
—⊟— Imaginary part of complex permittivity, ε"

FIGURE 9

(a)

(b)

(c)

FIGURE 10

10

FIGURE 11

FIGURE 12

**FIGURE 13**

```
                    ( Start )
                        │
                        ▼
┌──────────────────────────────────────────────┐
│ Forming an electromagnetic wave absorbing screen │──S10
└──────────────────────────────────────────────┘
                        │
                        ▼
┌──────────────────────────────────────────────┐
│ Selecting a position at which a resin-permeable, │──S20
│ highly conductive backing layer is to be located │
└──────────────────────────────────────────────┘
                        │
                        ▼
┌──────────────────────────────────────────────┐
│      Constructing a composite in a sandwich      │
│        structure with the resin-permeable,       │──S30
│ highly conductive backing layer located therein  │
└──────────────────────────────────────────────┘
                        │
                        ▼
┌──────────────────────────────────────────────┐
│   Layering the composite on the electromagnetic  │──S50
│            wave-absorbing screen                 │
└──────────────────────────────────────────────┘
                        │
                        ▼
                    ( End )
```

**FIGURE 14**

```
                    ( Start )
                        │
                        ▼
┌──────────────────────────────────────────────┐
│ Forming an electromagnetic wave absorbing screen │──S10
└──────────────────────────────────────────────┘
                        │
                        ▼
┌──────────────────────────────────────────────┐
│ Selecting a position at which a resin-permeable,  │──S20
│ highly conductive backing layer is to be located │
└──────────────────────────────────────────────┘
                        │
                        ▼
┌──────────────────────────────────────────────┐
│ Constructing a composite in a sandwich structure │
│   with the resin-permeable, highly conductive    │──S30
│        backing layer located therein             │
└──────────────────────────────────────────────┘
                        │
                        ▼
┌──────────────────────────────────────────────┐
│  Placing the electromagnetic wave absorbing      │──S40
│          screen on a SCRIMP mold                 │
└──────────────────────────────────────────────┘
                        │
                        ▼
┌──────────────────────────────────────────────┐
│  Layering the composite on the electromagnetic   │──S50
│            wave-absorbing screen                 │
└──────────────────────────────────────────────┘
                        │
                        ▼
                    ( End )
```

FIGURE 15

FIGURE 16

carbon fabric/epoxy laminates of various plies

FIGURE 17A

Carbon Black (CB) 5.30 wt%

FIGURE 17B

Carbon Nano Fiber (CNF) 2.08 wt%

FIGURE 17C

FIGURE 18A

FIGURE 18B

FIGURE 18C

## INTERNATIONAL SEARCH REPORT

| | International application No. |
|---|---|
| | **PCT/KR2011/008562** |

**A. CLASSIFICATION OF SUBJECT MATTER**

***H05K 9/00(2006.01)i, F03D 11/00(2006.01)i***

According to International Patent Classification (IPC) or to both national classification and IPC

**B. FIELDS SEARCHED**

Minimum documentation searched (classification system followed by classification symbols)
H05K 9/00; B32B 15/04; C08K 3/04; C08K 7/14; B32B 27/18; H01Q 1/24; H01B 3/00

Documentation searched other than minimum documentation to the extent that such documents are included in the fields searched
Korean Utility models and applications for Utility models: IPC as above
Japanese Utility models and applications for Utility models: IPC as above

Electronic data base consulted during the international search (name of data base and, where practicable, search terms used)
eKOMPASS (KIPO internal) & Keywords: microwave absorber, rear surface layer, support layer, composite material seat layer for dielectric loss, complex dielectric constant, carbon black, epoxy resin, rotor blade for wind power generator

**C. DOCUMENTS CONSIDERED TO BE RELEVANT**

| Category* | Citation of document, with indication, where appropriate, of the relevant passages | Relevant to claim No. |
|---|---|---|
| X | JP 2001-196782 A (TOYO CHEM. CO., LTD.) 19 July 2001<br>See abstract, claim 1, figure 1 and related description. | 1-36 |
| A | KR 10-0764659 B1 (SEOUL NATIONAL UNIVERSITY INDUSTRY FOUNDATION) 08 October 2007<br>See abstract, claim 1, figure 1 and related description. | 1-36 |
| A | KR 10-2009-0027379 A (SEOUL NATIONAL UNIVERSITY INDUSTRY FOUNDATION) 17 March 2009<br>See abstract, claim 1, figures 1,5 and related description. | 1-36 |
| A | JP 04-025114 U (HATAYAMA SEKI) 28 February 1992<br>See abstract, claim 1, figures 1-3 and related description. | 1-36 |
| A | JP 2006-114877 A (SUZUKI SOGYO CO., LTD.) 27 April 2006<br>See abstract, claims 1-2, 8, 11 figures 5-6 and related description. | 1-36 |

☐ Further documents are listed in the continuation of Box C. ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 22 MARCH 2012 (22.03.2012) | **04 APRIL 2012 (04.04.2012)** |

| Name and mailing address of the ISA/KR | Authorized officer |
|---|---|
| Korean Intellectual Property Office<br>Government Complex-Daejeon, 139 Seonsa-ro, Daejeon 302-701, Republic of Korea | |
| Facsimile No. 82-42-472-7140 | Telephone No. |

Form PCT/ISA/210 (second sheet) (July 2009)

INTERNATIONAL SEARCH REPORT
Information on patent family members

International application No.

**PCT/KR2011/008562**

| Patent document cited in search report | Publication date | Patent family member | Publication date |
|---|---|---|---|
| JP 2001-196782 A | 19.07.2001 | NONE | |
| KR 10-0764659 B1 | 08.10.2007 | NONE | |
| KR 10-2009-0027379 A | 17.03.2009 | NONE | |
| JP 04-025114 U | 28.02.1992 | NONE | |
| JP 2006-114877 A | 27.04.2006 | NONE | |

Form PCT/ISA/210 (patent family annex) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **J.B. KIM ; C.G. KIM.** *Composite Science and Technology,* 2010, vol. 70, 1748-1754